# FASCICULE DE BREVET EUROPEEN

(11) **EP 3 497 711 B1**
(45) Date de publication et mention de la délivrance du brevet: **13.05.2020**
(21) Numéro de dépôt: 17752306.5
(22) Date de dépôt: 25.07.2017
(51) Int. Cl.: H01L 21/02, H01L 21/033, H01L 21/20

(54) **PROCÉDÉ DE FABRICATION D'UNE COUCHE ÉPITAXIÉE SUR UNE PLAQUE DE CROISSANCE**
VERFAHREN ZUR HERSTELLUNG EINER EPITAKTISCHEN SCHICHT AUF EINEM ZÜCHTUNGSSUBSTRAT
METHOD FOR PRODUCING AN EPITAXIAL LAYER ON A GROWTH WAFER

(30) Priorité: 11.08.2016 FR 1657712
(43) Date de publication de la demande: 19.06.2019
(73) Titulaire: Commissariat à l'Énergie Atomique et aux Énergies Alternatives, 75015 Paris (FR)
(72) Inventeur: MORICEAU, Hubert, 38120 SAINT-EGREVE (FR); CHARLES, Matthew, 38000 GRENOBLE (FR); MORALES, Christophe, 38220 St Pierre de Mesage (FR)
(74) Mandataire: Bronchart, Quentin
(86) Numéro de dépôt international: PCT/EP2017/068807
(87) Numéro de publication internationale: WO 2018/028982

(56) Documents cités:
- US-A1- 2012 034 768
- US-A1- 2012 083 098
- US-A1- 2013 069 072
- US-A1- 2015 028 457

## Description

### DOMAINE TECHNIQUE DE L'INVENTION

La présente invention concerne la maîtrise de la qualité de formation d'une couche épitaxiée sur une plaque de croissance, en particulier au niveau des bords de la plaque. L'invention trouvera comme application avantageuse, mais non limitative, la formation d'une couche de nitrure de gallium par épitaxie sur une plaque de silicium.

Les domaines d'application de ce type de dépôts sont en particulier la fabrication de composants micro-électroniques, tels que des composants de puissance électrique, des composants de radiofréquence, des composants pour l'éclairage, etc.

### ÉTAT DE LA TECHNIQUE

Il existe un vrai problème de qualité des dépôts de nitrure de gallium ou plus généralement de films d'alliage d'éléments des colonnes III et V du tableau périodique des éléments, en particulier sur les bords des plaques de silicium qui servent de support mécanique et de germes cristallins. Les solutions connues consistent à faire croître par épitaxie des films monocristallins, par des techniques de croissance classiques par exemple en micro-électronique, parmi lesquels on peut citer l'épitaxie en phase vapeur aux organométalliques ou MOVPE (pour « metalorganic chemical vapor epitaxy » selon la terminologie anglo-saxonne).

Actuellement, des défauts de croissance ou des dépôts parasites apparaissent sur les bords des plaques de silicium. Ces défauts de croissance sont notamment dus au changement d'orientation cristalline au niveau des bords de la plaque. Ces défauts de croissance ou dépôts parasites sont la source de particules qui peuvent se détacher des bords de la plaque de silicium lors des étapes de procédé ultérieures au dépôt du nitrure de gallium. Egalement, le frottement des bords des plaques de silicium dans des cassettes, par exemple lors de leur manipulation en salle blanche, peut dégrader rapidement l'environnement desdites cassettes.

Pour résoudre ce problème, la solution conventionnelle consiste à protéger les bords des plaques en mettant en oeuvre le procédé suivant :
- déposer un film de protection sur une face de la plaque de silicium ;
- déposer un film d'une résine photosensible sur le film de protection ;
- réaliser par photolithographie une ouverture dans le film de résine photosensible pour définir, sur ladite face de la plaque silicium, une première surface exposée et délimitée par ce qui reste dudit au moins un film de résine photosensible ;
- graver le film de protection à l'aplomb de ladite première surface,
- déposer par épitaxie un film de nitrure de gallium à l'aplomb de ladite première surface ;
- retirer ce qui reste du film de protection, notamment sur les bords de la plaque de silicium.

Toutefois, cette solution n'est pas satisfaisante pour les raisons suivantes.

Il faut au moins quatre étapes technologiques (dépôt, couchage de résine, photolithographie, gravure) pour réaliser la protection superficielle des bords de la plaque de silicium et l'ouverture définissant la première surface qui constitue la zone utile Zu au dépôt par épitaxie du film de nitrure de gallium. Les procédés connus sont donc relativement complexes et coûteux.

Par ailleurs, la lithographie utilisée pour définir la zone utile Zu implique actuellement une zone d'exclusion Ze relativement importante (s'étendant typiquement sur 1 à 3 mm) sur les bords de la plaque de silicium. Il s'en suit qu'une surface importante du substrat de croissance n'est pas rentabilisée.

En outre, la gravure (en une ou plusieurs étapes) du film de protection à l'aplomb de la zone utile Zu peut engendrer des dommages à la surface ou sous la surface dans cette zone, suivant la nature des films de protection. Ces dommages peuvent être sources de défauts lors du dépôt par épitaxie du film de nitrure de gallium à l'aplomb de la zone utile Zu.

L'objet de l'invention est de répondre, au moins en partie, aux limitations précédemment exposées.

US 2012/083098 A1, voir en particulier la figure 3, illustre un processus de transfert de couche du type "Smart-Cut." Lorsque le substrat donneur est joint au substrat receveur et recuit, une couche de revêtement est appliquée qui recouvre les surfaces exposées et les côtés. Il n'y a aucune mention de problèmes de génération de particules dans la zone marginale.

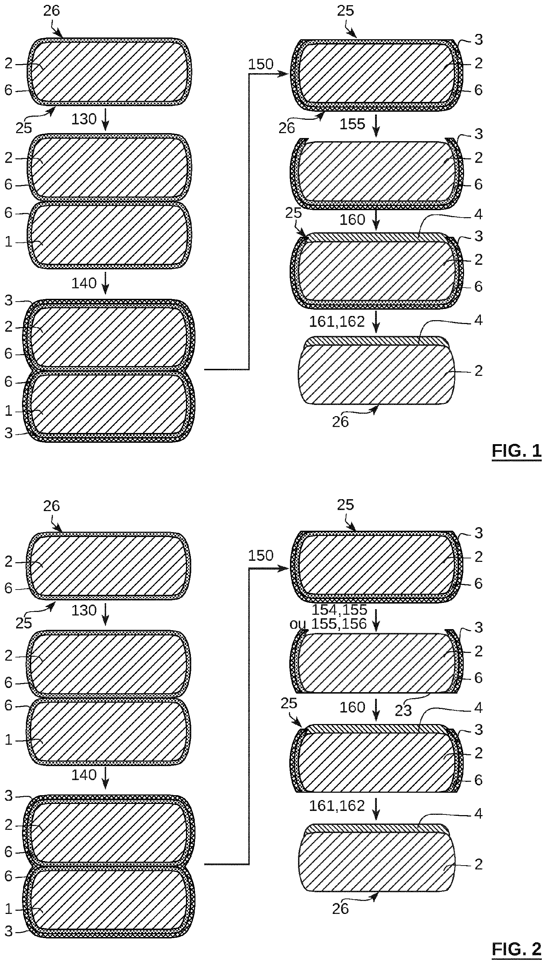

Le document US 2015/028457 A1 résout le problème du dépôt indésirable dans la zone périphérique (voir figure 2) au moyen d'un traitement de chanfreinage (voir figure 9b).

Le document US 2013/069072 A1 applique une exposition à un plasma oxygène (figure 4A) qui transforme la couche 120 de AIN en AINO. Il en résulte que la croissance est amorphe dans la zone marginale et que les fissures radiales provenant de la zone marginale ne posent aucun problème.

US 2012/034768 A1, voir en particulier les figures 1, 2, résout le problème des fissures / particules dans la zone marginale pendant la croissance épitaxiale par dépôt d'une couche d'inhibition de la croissance 4 dans la zone marginale.

### RÉSUMÉ DE L'INVENTION

Pour atteindre cet objectif, selon un mode de réalisation, la présente invention prévoit un procédé de fabrication d'une couche épitaxiée sur une plaque de croissance comprenant les étapes consistant à :
- Fournir un substrat de masquage ;
- Fournir au moins une plaque de croissance, chaque plaque de croissance comprenant un chanfrein sur au moins un bord ;
- Coller ladite au moins une plaque de croissance sur le substrat de masquage, de sorte que le substrat de masquage masque une première surface et expose une deuxième surface de ladite au moins une plaque de croissance, ladite deuxième surface comprenant le chanfrein et ladite première surface étant au moins en partie délimitée par le chanfrein ;

- Déposer au moins un film de protection au moins sur une partie du chanfrein de ladite au moins une plaque de croissance, le dépôt dudit au moins un film de protection étant réalisé via une méthode permettant de recouvrir au moins en partie le chanfrein de la plaque de croissance ;
- Décoller ladite au moins une plaque de croissance depuis le substrat de masquage, ledit au moins un film de protection exposant et délimitant alors la première surface de la plaque de silicium du fait du masquage de ladite première surface par le substrat de masquage durant le dépôt dudit au moins un film de protection ; et
- Déposer une couche épitaxiée à partir de ladite première surface de ladite au moins une plaque de croissance.

Ainsi, le procédé selon l'invention utilise astucieusement le chanfrein habituellement présent sur les plaques de croissance afin d'auto-positionner le film de protection sur le chanfrein tout en évitant de le positionner sur la première surface du fait de son masquage par le substrat de masquage. En effet, au droit du chanfrein, le substrat de masquage est à distance de la plaque de croissance. Il existe donc, au droit du chanfrein, un espace accessible sur lequel les espèces formant le film de protection peuvent venir se déposer lors de la formation du film de protection. Après décollement, la croissance épitaxiale est réduite, voire évitée, au niveau du chanfrein recouvert du film de protection alors que la croissance peut avoir lieu au niveau de la première surface car la première surface n'est pas recouverte par le film de protection.

Ainsi, le procédé selon l'invention permet la fabrication d'une couche épitaxiée, par exemple de nitrure de gallium, sur au moins une plaque de croissance, par exemple une plaque de silicium, en ne nécessitant aucune étape de photolithographie. Le procédé selon l'invention permet ainsi de réduire la complexité et le coût des solutions connues.

Par ailleurs, le procédé selon l'invention permet la fabrication d'une couche épitaxiée en maximisant la zone utile Zu servant à la croissance par épitaxie sur chaque plaque de croissance, cette maximisation de la zone utile étant le corolaire de la minimisation de la zone d'exclusion Ze qui s'étend au plus sur le chanfrein de la plaque de croissance. Par rapport aux solutions connues, pour une même surface de la plaque de croissance, le procédé selon l'invention permet ainsi de fabriquer une plus grande surface de couche épitaxiée. Le coût de production de la couche épitaxiée est donc réduit.

Selon un autre mode de réalisation, la présente invention prévoit un procédé de fabrication d'une couche épitaxiée sur une plaque de croissance comprenant les étapes consistant à :
- fournir deux plaques de croissance, chaque plaque de croissance comprenant un chanfrein sur au moins un bord ;
- Coller les deux plaques de croissance l'une sur l'autre, de sorte que chaque plaque de croissance masque une première surface et expose une deuxième surface de l'autre plaque de croissance ; la deuxième surface de chaque plaque de croissance comprend le chanfrein de cette plaque de croissance et la première surface de chaque plaque de croissance est au moins en partie délimitée par le chanfrein de cette plaque de croissance ;
- Déposer au moins un film de protection au moins sur une partie du chanfrein d'au moins une des deux plaques de croissance, le dépôt dudit au moins un film de protection étant réalisé via une méthode permettant de recouvrir au moins en partie le chanfrein de la plaque de croissance ;
- Décoller lesdites deux plaques de croissance entre elles, ledit au moins un film de protection exposant et délimitant la première surface de l'une des deux plaques de croissance du fait du masquage de ladite première surface par l'autre des deux plaques durant le dépôt dudit au moins un film de protection ; et
- Déposer une couche épitaxiée à partir de la première surface de ladite au moins une des deux plaques de croissance.

Dans ce mode de réalisation, l'une des deux plaques de croissance sert de substrat de masquage à l'autre des deux plaques de croissance, et *vice versa.* La zone utile Zu d'une des deux plaques de croissance est masquée au dépôt du film de protection par l'autre des deux plaques de croissance.

Ainsi, le procédé selon l'invention permet la fabrication d'une couche épitaxiée concomitamment sur deux plaques de croissance en ne nécessitant aucune étape de photolithographie et en maximisant la zone utile Zu sur laquelle la couche est épitaxiée.

Ce mode de réalisation permet de réduire encore plus fortement le temps et le coût d'obtention d'une large surface de couche épitaxiée.

Ainsi, l'invention est particulièrement avantageuse pour la fabrication de composants micro-électroniques, tels que des composants de puissance électrique, des composants de radiofréquence, des composants pour l'éclairage, etc.

Par composant microélectronique, on entend tout type de dispositif réalisé avec des moyens de la microélectronique. Ces dispositifs englobent notamment en plus des dispositifs à finalité purement électronique, des dispositifs micromécaniques ou électromécaniques (MEMS, NEMS...), ainsi que des dispositifs optiques ou optoélectroniques (MOEMS...).

Les autres objets, caractéristiques et avantages de la présente invention apparaîtront à l'examen de la description suivante et des dessins d'accompagnement. Il est entendu que d'autres avantages peuvent être incorporés.

### BRÈVE DESCRIPTION DES FIGURES

Les buts, objets, ainsi que les caractéristiques et avantages de l'invention ressortiront mieux de la description détaillée d'un mode de réalisation de cette dernière qui est illustré par les dessins d'accompagnement suivants dans lesquels :
La FIGURE 1 est une représentation schématique de différentes étapes d'un procédé de fabrication selon un mode de réalisation de l'invention.
La FIGURE 2 est une représentation schématique de différentes étapes d'un procédé de fabrication selon un autre mode de réalisation de l'invention.
La FIGURE 3 est un ordinogramme de différentes étapes du procédé de fabrication selon un mode de réalisation de l'invention.
La FIGURE 4 est une vue schématique en coupe d'un bord chanfreiné d'une plaque de silicium.
La FIGURE 5 est une représentation schématique d'une étape du procédé de fabrication selon un autre mode de réalisation que les modes de réalisation de l'invention illustrés sur les figures 1 et 2.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier, les épaisseurs relatives des différentes couches et films ne sont pas représentatives de la réalité.

De manière facultative, l'invention peut en outre présenter au moins l'une quelconque des caractéristiques optionnelles suivantes :
- le substrat de masquage peut être de dimensions supérieures aux dimensions de ladite au moins une plaque de croissance de sorte que plusieurs plaques de croissance peuvent être collées sur le substrat de masquage, et de préférence le substrat de masquage est réutilisable pour effectuer successivement plusieurs séquences d'étapes avec des plaques de croissance différentes, chaque séquence comprenant au moins ledit collage et ledit décollement. Ainsi, le substrat est réutilisable pour implémenter au moins une fois de plus le procédé de fabrication en fournissant à nouveau au moins une plaque de croissance.
- Le substrat de masquage peut être transparent pour permettre le décollement par application d'un rayonnement, de préférence laser, au moins sur une partie de ladite première surface à travers le substrat de masquage.
- Le collage est réalisé de sorte que ladite première surface exposée et délimitée par ledit au moins un film de protection soit maximale.
- Le collage peut être réalisé par collage direct.
- Ledit au moins un film de protection comprend au moins un film de nitrure, de préférence un film de nitrure de silicium ou un film d'oxyde, de préférence un film d'oxyde de silicium.
- Le procédé peut comprendre, avant le collage de la plaque de croissance sur le substrat de masquage, une étape consistant à déposer au moins une couche de nucléation comprenant un film d'un nitrure, par exemple choisi parmi le nitrure d'aluminium (AIN), le nitrure d'indium (InN), le nitrure d'aluminium-gallium (AIGaN), le nitrure d'indium-gallium (InGaN) au moins sur la première surface de la plaque de croissance. On autorise ainsi le dépôt ultérieur de la couche épitaxiée par un phénomène de croissance sélective.
- Le procédé peut comprendre :
   ∘ avant l'étape de collage, une étape consistant à générer une couche additionnelle au moins à l'aplomb de la première surface de ladite au moins une plaque de croissance; la génération de la couche additionnelle comprend de préférence l'un parmi une oxydation en surface de ladite au moins une plaque de croissance et un dépôt de la couche additionnelle ; et
   ∘ après le décollement de ladite au moins une plaque de croissance depuis le substrat de masquage et avant l'étape de dépôt de la couche épitaxiée, une étape consistant à retirer la couche additionnelle à l'aplomb de ladite première surface exposée et délimitée par ledit au moins un film de protection ; le retrait de ladite couche additionnelle à l'aplomb de ladite première surface comprend de préférence sa gravure humide sélectivement au film de protection, par exemple par une solution d'acide fluorhydrique.
   ∘ En outre, le procédé peut comprendre, avant la génération de la couche additionnelle, une étape consistant à déposer au moins une couche de nucléation comprenant un film d'un nitrure choisi parmi le nitrure d'aluminium (AIN), le nitrure d'aluminium-gallium (AIGaN), le carbure de silicium (SiC) au moins sur la première surface de ladite au moins une plaque de croissance; la génération de la couche additionnelle peut être réalisée par son dépôt au moins à l'aplomb de ladite première surface.
   ∘ Le collage de ladite au moins une plaque de croissance sur le substrat de masquage peut être précédé d'un lissage, et de préférence d'un nettoyage, de la couche additionnelle au moins à l'aplomb de ladite première surface.
   ∘ En outre, le procédé peut comprendre, après le collage de ladite au moins une plaque de croissance sur le substrat de masquage et avant le dépôt de la couche épitaxiée, une étape consistant à retirer la couche additionnelle à l'aplomb de ladite deuxième surface ; le retrait de ladite couche additionnelle à l'aplomb de ladite deuxième surface comprend de préférence sa gravure sélectivement au film de protection, par exemple par une solution d'acide fluorhydrique ; et le collage de ladite au moins une plaque de croissance sur le substrat de masquage comprend de préférence un traitement thermique pour renforcer le collage et éviter ainsi l'infiltration d'une solution d'attaque chimique à l'aplomb de ladite première surface lors de la gravure sélective de la couche additionnelle.
   ∘ Le substrat de masquage peut comprendre des vias pour permettre l'amenée jusqu'à la couche additionnelle située à l'aplomb de la première surface d'une solution d'attaque chimique de la couche additionnelle. Le procédé permet ainsi un décollement chimique de la plaque de croissance depuis le substrat de masquage.

Par ailleurs, et de manière également facultative, l'invention peut en outre présenter au moins l'une quelconque des caractéristiques optionnelles suivantes :
- l'étape de dépôt dudit au moins un film de protection comprenant le dépôt dudit au moins un film de protection sur une face arrière de la plaque de croissance opposée à une face avant comprenant ladite première surface, le procédé peut comprendre en outre, après le décollement de ladite au moins une plaque de croissance depuis le substrat de masquage et avant l'étape de dépôt de la couche épitaxiée, une étape consistant à retirer, depuis ladite face arrière au moins ledit au moins un film de protection jusqu'à exposer une troisième surface de la plaque de croissance opposée à ladite première surface, cette troisième surface restant éventuellement délimitée par ce qui reste du film de protection sur au moins un bord de la plaque de croissance ; ce retrait comprend de préférence le retrait mécanique par meulage d'au moins ledit au moins un film de protection au moins à l'aplomb de ladite troisième surface.
- Le dépôt de la couche épitaxiée peut être précédé d'un nettoyage d'au moins la première surface de ladite au moins une plaque de croissance.
- Le procédé peut comprendre en outre, après l'étape de dépôt de la couche épitaxiée, une étape consistant à retirer au moins ce qui reste dudit au moins un film de protection jusqu'à exposer toute la surface de la plaque de croissance non recouverte de la couche épitaxiée.
   ∘ Le retrait de ce qui reste dudit au moins un film de protection peut de préférence comprendre la gravure humide sélectivement au film de protection, par exemple par une solution d'acide fluorhydrique, de ce qui reste de la couche additionnelle ; ce retrait est de préférence précédé d'au moins une ouverture dudit au moins film de protection pour permettre l'amenée de ladite solution d'attaque chimique.
   ∘ La couche épitaxiée recouvrant par ses bords en partie ledit au moins un film de protection recouvrant lui-même le chanfrein, le procédé peut comprendre en outre, après le retrait de ce qui reste dudit au moins un film de protection, une étape consistant à retirer les bords de la couche épitaxiée, par exemple par meulage suivi de préférence par une attaque chimique propre à corriger les imperfections du meulage.

La couche additionnelle peut comprendre une couche d'oxyde de silicium qui présente notamment l'intérêt de pouvoir être attaquée par gravure humide sélectivement à un film de nitrure de silicium qui composerait au moins en partie ledit au moins un film de protection ; il est dès lors possible de retirer ledit au moins un film de protection par son soulèvement lors du retrait par gravure humide de la couche additionnelle qui est sous-jacente audit au moins un film de protection.

### DESCRIPTION DÉTAILLÉE DE L'INVENTION

Il est précisé que dans le cadre de la présente invention, le terme « sur » ou « (re)couvre » ou « sous-jacent » ou leurs équivalents ne signifient pas forcément « au contact de ». Ainsi par exemple, le dépôt d'une première couche sur une deuxième couche, ne signifie pas obligatoirement que les deux couches sont directement au contact l'une de l'autre, mais cela signifie que la première couche recouvre au moins partiellement la deuxième couche en étant soit directement à son contact, soit en étant séparée d'elle par au moins une autre couche.

On entend par déposer, générer ou retirer quelque chose « à l'aplomb de » une surface, le fait de déposer, générer ou retirer ce quelque chose sur ou depuis une zone située au moins en partie en vis-à-vis de ladite surface, de sorte que ladite zone est sensiblement plane si ladite surface est plane et de sorte que ladite zone suit les variations de ladite surface si cette dernière n'est pas plane ; autrement dit, chaque droite localement perpendiculaire à ladite surface présente un point ou un segment appartenant à ladite zone.

On entend par « collage direct » un collage sans apport de matière adhésive (de type colle ou polymère notamment) qui consiste en la mise en contact de surfaces relativement lisses, par exemple réalisé à température ambiante et sous atmosphère ambiant, afin de créer une adhérence entre elles.

Selon un mode de réalisation, le collage direct de deux composants signifie que le collage est obtenu par les liens chimiques qui s'établissent entre les deux surfaces mises en contact. Ces deux surfaces présentent des rugosités suffisamment faibles pour que les forces de Van der Waals assurent, de préférence à elles seules, un maintien des deux composants entre eux.

Le collage direct est en outre obtenu sans nécessiter l'application d'une pression importante sur la structure à assembler. Une légère pression pourra simplement être appliquée localement pour initier le collage.

Le collage direct implique ou non une couche intermédiaire de collage (par exemple une couche d'oxyde de silicium).

Dans le cadre de l'invention, il peut s'agir du collage direct de deux substrats présentant en surface des matériaux de même nature, typiquement deux plaques de silicium (Si) ou deux substrats dont les faces en contact sont chacune recouvertes d'une couche de même nature, typiquement un film d'oxyde. Les faces à assembler peuvent également être de natures différentes dans la mesure où elles sont compatibles avec un collage direct.

On entend par « couche de nucléation » une couche dont les propriétés favorisent la croissance par épitaxie d'une couche que l'on cherche à faire croître.

Le procédé selon l'invention va maintenant être décrit en référence aux figures 1 à 5.

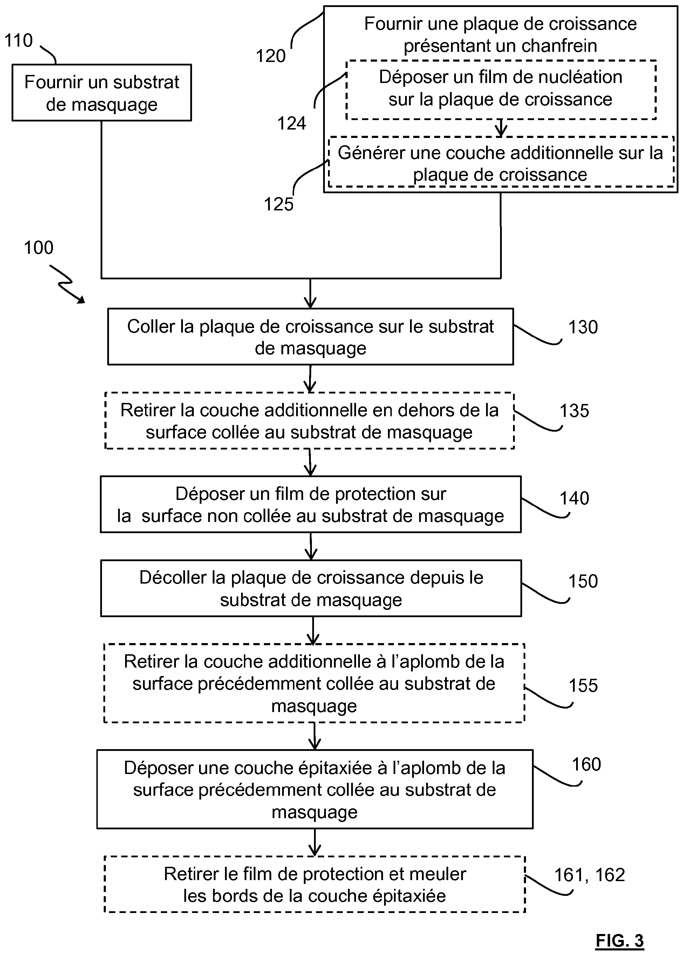

En référence à la figure 3, sur laquelle les étapes représentées dans des cadres en tirets sont optionnelles, le procédé de fabrication comprend tout d'abord les étapes consistant à :
- fournir 110 un substrat de masquage 1,
- fournir 120 au moins une plaque de croissance 2.

La plaque de croissance 2 va servir de support pour l'épitaxie de la couche utile. Typiquement la plaque de croissance 2 est une plaque de silicium (Si) ou à base de silicium. De préférence, la plaque de croissance 2 est monocristalline. Une telle plaque de croissance est souvent qualifiée par le vocable anglais de « wafer ».

Chaque plaque de croissance 2 peut prendre la forme d'un disque présentant au moins une épaisseur de l'ordre de 1 mm, un diamètre de 200 ou 300 mm et au moins une face présentant une orientation cristalline [111]. Toutefois, la forme de chaque plaque de croissance 2 n'est nullement limitative ; la plaque de croissance 2 peut aussi être de forme parallélépipédique par exemple. De préférence, la plaque 2 présente une face avant 25 et une face arrière 26 sensiblement planes.

Selon certains modes de réalisation du procédé de fabrication 100, le substrat de masquage 1 est lui-même une plaque de croissance 2, par exemple une plaque de silicium, de préférence monocristallin, comprenant un chanfrein 20 sur au moins un bord.

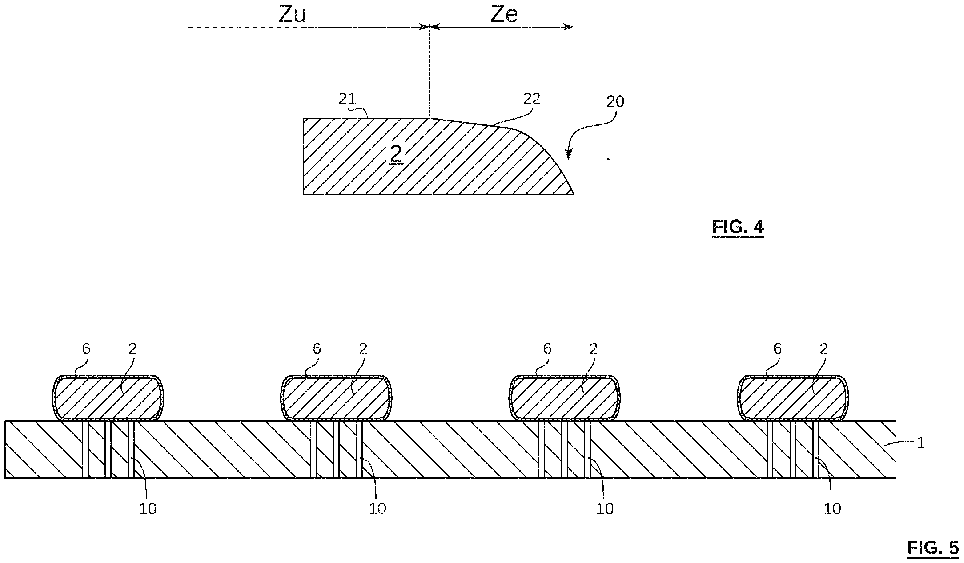

En référence à la figure 4, au moins un chanfrein 20 de chaque plaque de croissance 2 s'étend sur au moins un bord, et de préférence sur tout le bord, de la plaque de croissance 2. Il définit ainsi un pourtour sur la face avant 25 de la plaque de croissance 2.

Le type de chanfrein 20 décrit ci-dessous peut être réalisé de façon connue, voire normée, notamment parce qu'un bord droit (non chanfreiné) montrerait une certaine fragilité que l'on souhaite éviter. Le type de chanfrein 20 décrit ci-dessous n'est pour autant limité par aucune exigence de norme(s) ; notamment, sa forme et ses dimensions peuvent être optimisées, dans les limites des connaissances générales de l'homme du métier, pour une utilisation selon le procédé de fabrication de l'invention.

Le chanfrein 20 de chaque plaque de croissance 2 s'étend de préférence depuis au moins une face de chaque plaque de croissance 2. Chaque chanfrein 20 peut s'étendre plus particulièrement sur un bord de la plaque de croissance 2 depuis au moins une face sensiblement plane, avant 25 et/ou arrière 26, de la plaque de croissance 2. Cette extension peut prendre la forme d'un affaissement régulier sur environ 200 µm, puis peut prendre la forme d'un affaissement abrupte jusqu'à rejoindre le bord de la plaque de croissance 2 situé dans son épaisseur, lesdits affaissements étant à considérer par rapport à un prolongement continu de la face sensiblement plane de la plaque de croissance 2 depuis laquelle s'étend le chanfrein 20. Le chanfrein 20 de chaque plaque de croissance 2 peut s'étendre par exemple sur environ 0,5 mm de longueur sur le bord de la plaque de croissance 2 ou équivalemment depuis une face de la plaque de croissance 2.

Chaque chanfrein 20 de chaque plaque de croissance 2 peut donc délimiter une face avant 25 ou arrière 26 sensiblement plane de cette plaque de croissance 2. Chaque face sensiblement plane délimitée par un chanfrein 20 peut correspondre à une première surface 21 de la plaque de croissance 2. Chaque chanfrein 20 s'étend par définition sur une deuxième surface 22 de la plaque de croissance 2. Les première et deuxième surfaces de chaque plaque de croissance 2 ne sont pas nécessairement complémentaires l'une de l'autre pour former toute la surface de la plaque de croissance 2. Chaque plaque de croissance 2 peut comprendre deux premières surfaces 21 correspondant aux faces sensiblement planes avant 25 et arrière 26 de la plaque de croissance 2 et une deuxième surface 22 s'étendant depuis et entre lesdites deux premières surfaces 21 ; la deuxième surface 22 comprend alors deux chanfreins 20 s'étendant respectivement depuis chaque face 25, 26 sensiblement plane de la plaque de croissance 2.

Dans la mesure où les plaques de croissance 2 sont fabriquées conventionnellement et donc fournies avec un chanfrein 20 du type décrit ci-dessus, le procédé de fabrication 100 selon l'invention permet d'utiliser avantageusement l'existence de ce chanfrein 20 pour atteindre les objectifs fixés.

Pour atteindre ses objectifs, l'invention prévoit un dépôt 140 d'au moins un film de protection 3 en présence d'un substrat de masquage 1 faisant office de masque mécanique.

Selon les modes de réalisation illustrés par les figures 1 et 2, le masque mécanique est réalisé à partir d'un collage 130 d'une première plaque de croissance 2 sur une deuxième plaque de croissance 2. Un des avantages de cette approche, selon laquelle le substrat de masquage 1 est une plaque de croissance 2, est la possible préparation concomitante de deux plaques de croissance 2 pour la future épitaxie 160. De préférence, mais de façon non limitative, les deux plaques de croissance 2 présentent les mêmes forme et dimensions.

Le collage 130 peut être réalisé par une technique dite de collage direct, consistant à mettre en contact étroit deux surfaces, ici de préférences deux premières surfaces 21 sans apport de matière adhésive. Dans cet exemple non limitatif, les deux plaques de croissance 2 sont de préférence des plaques de silicium.

Dans ces conditions, les chanfreins 20 de chacune des deux plaques de silicium 2 sont trop éloignés l'un de l'autre pour permettre une adhérence entre eux . Cette zone, où l'adhérence des plaques de silicium 2 n'est pas possible, est alors accessible pour le dépôt 140 d'un film de protection 3. On peut considérer que sitôt que les chanfreins 20 des deux plaques de silicium 2 sont distants de quelques nanomètres (typiquement d'une distance comprise entre 5 et 10 nm) les deux plaques de silicium ne sont plus en contact et le dépôt 140 du film de protection 3 y sera effectif.

On procède ensuite à la séparation des surfaces collées de sorte à dégager des zones utiles dans lesquelles l'épitaxie pourra sélectivement être réalisée. Ces zones utiles sont définies par le dépôt 140 localisé du film de protection 3 : on évite ainsi toute étape de lithographie de leur réalisation. Par construction, la zone utile Zu s'étend sur au moins toute une face sensiblement plane de la ou de chaque plaque de silicium 2 (correspondant par définition à une première surface 21 de la plaque de silicium 2) et potentiellement sur une partie du chanfrein 20 (non recouvert par le film de protection 3).

Une approche est décrite ici, à titre d'exemple et en référence aux figures 1 à 3, qui comprend la génération 125 d'une couche additionnelle 6 par exemple de SiO₂, d'AIN, de SiC, ou d'AIGaN, et le dépôt 140 du film de protection 3, par exemple de nitrure ou d'oxyde.

Le rôle de la couche additionnelle 6 est l'un au moins parmi ceux consistant à :
- protéger la future zone utile Zu à l'épitaxie 160,
- favoriser un collage 130 direct, avec les moyens classiques de microtechnologie, des deux plaques de silicium 2 entre elles (ou plus généralement d'une plaque de croissance 2 sur le substrat de masquage 1),
- permettre d'obtenir un collage 130 avec une énergie de collage faible, donc un collage démontable sans arrachement, dans la zone utile Zu,
- permettre d'adapter l'énergie de collage 130, par exemple en modifiant la topologie ou la rugosité de la surface à coller,
- permettre d'absorber les éventuelles espèces gazeuses dégazées pendant les traitements thermiques subis par la structure collée, ces traitements thermiques étant impliqués au moins dans le dépôt 140 du film de protection 3
- servir de couche de nucléation pour l'épitaxie (si la couche additionnelle est en AIN, SiC ou AIGaN).

En outre, si la couche additionnelle 6 est en AIN, SiC ou AIGaN et le film de protection 3 en oxyde, on pourra obtenir une croissance sélective de GaN sur cette couche additionnelle. La couche d'oxyde restera à nu et pourra être alors soit conservée, soit facilement éliminée.

Si la couche additionnelle 6 est en oxyde et le film de protection 3 en nitrure, pendant le dépôt 160 de la couche épitaxiée, un dépôt de basse qualité pourra se former sur le film de protection 3 qui pourra avantageusement être retiré 161 par lift off grâce à la présence de la couche additionnelle 6 présente uniquement sous le film de protection. Le processus correspondant sera détaillé ci-dessous.

Plus particulièrement, le retrait 161 peut être obtenu par gravure humide à l'aide par exemple d'une solution d'acide fluorhydrique, de ce qui reste de la couche additionnelle 6 entrainant le retrait du film de protection 3 et du dépôt de basse qualité sous-jacent. Le retrait 161 peut en outre de préférence être précédé par la réalisation d'au moins une ouverture du film de protection 3 pour permettre l'amenée jusqu'à la couche additionnelle 6 de la solution de gravure.

L'utilisation d'une solution d'acide fluorhydrique est avantageuse car cette solution grave le film 6 d'oxyde de silicium et ne grave pas le film de protection 3 fait de nitrure de silicium, ni la couche épitaxiée 4 et l'éventuelle couche de nucléation.

Le rôle du film de protection 3 est l'un au moins parmi ceux consistant à :
- réaliser un effet de barrière d'interaction pour éviter la formation de phases parasites à partir de nitrure de gallium et de silicium,
- lorsque le film de protection est en nitrure de silicium et est déposé 140 uniquement sur le chanfrein 20, permettre de retirer 155 la couche additionnelle 6 d'oxyde à l'aplomb de ladite première surface 21 exposée et délimitée par le film de protection 3, tout en protégeant le chanfrein; ce retrait 155 comprend alors par exemple simplement la gravure humide de la couche additionnelle 6 à l'aplomb de ladite première surface 21 par une solution d'attaque chimique, par exemple une solution d'acide fluorhydrique.

Après avoir décrit en détail la couche additionnelle 6 et le film de protection 3, les différentes étapes du procédé selon l'invention vont maintenant être décrites en référence aux figures 1 à 3. Dans cet exemple, le substrat de masquage 1 et la plaque de croissance 2 sont en silicium et la couche épitaxiée 4 est un film de nitrure de gallium, sans que ces matériaux soient limitatifs de l'invention. Par exemple, la couche épitaxiée peut être un film de nitrure d'aluminium (AIN).
- Partant de deux de plaques de silicium 2, on génère 125 à la surface d'au moins une de ces plaques, et plus particulièrement au moins à l'aplomb de la première surface 21 d'au moins une de ces plaques, une couche additionnelle 6 en oxyde de silicium, par exemple par oxydation thermique dans un four. Les deux plaques 2 sont destinées à être collées 130 entre elles par des surfaces de leur couche d'oxyde de silicium 6 respective. Les surfaces à coller peuvent avantageusement être préparées pour permettre un collage direct : elles peuvent subir notamment des étapes de lissage, par exemple par polissage mécano-chimique connu sous l'acronyme CMP pour atteindre la rugosité requise ainsi que des étapes de nettoyage pour notamment renforcer si besoin leur hydrophilie.
- Les deux plaques de silicium 2 sont ensuite mises en contact et le collage 130 est induit ; comme expliqué ci-dessus, l'adhérence n'est pas possible sur le bord des plaques de silicium 2 au niveau de leur chanfrein 20 respectif du fait de l'éloignement des surfaces. Plus généralement, si le substrat de masquage 1 ne présente pas de chanfrein ou ne présente pas un chanfrein au droit de celui de la plaque de croissance 2 collée au substrat, le chanfrein 20 de cette plaque est tout de même à distance du substrat 1.
- On dépose 140 le film de protection 3 en nitrure de silicium, par exemple par dépôt chimique en phase vapeur dans un four sous pression sous-atmosphérique ou LPCVD (pour « low pressure chemical vapor déposition » selon la terminologie anglo-saxonne), et en tout cas par une technique permettant de couvrir au moins en partie le chanfrein 20 d'au moins une des deux plaques de silicium 2 collées.
- De façon illustrée uniquement sur la figure 2, pour l'une au moins des deux plaques de silicium 2, on peut retirer 154, 156, depuis la face arrière 26, le film de protection 3 et la couche additionnelle 6 jusqu'à exposer une troisième surface 23, ladite troisième surface 23 étant de fait opposée à ladite première surface 21 ; cette troisième surface 23 est éventuellement délimitée par ce qui reste du film d'oxyde de silicium 6 et du film de nitrure de silicium 3 sur au moins un bord de la plaque 2 considérée ; ce retrait 154, 156 comprend le cas échant le meulage du film de nitrure de silicium 3 et du film d'oxyde de silicium 6 au moins à l'aplomb de ladite troisième surface 23. Le meulage peut être remplacé ou complété par une étape de polissage mécano-chimique (CMP).
- Précédemment ou postérieurement au retrait 154, 156 ci-dessus, on décolle 150 les deux plaques de silicium 2 entre elles ; ainsi, deux plaques de silicium 2 ont potentiellement été préparées de façon concomitante pour la future épitaxie 160 ; à ce stade, le film de nitrure de silicium 3 délimite la première surface 21 de l'une au moins des deux plaques de silicium 2 du fait du masquage de ladite première surface 21 par l'autre des deux plaques de silicium 2 durant le dépôt 140 du film de nitrure de silicium 3. Le décollement peut être mis en oeuvre par tout moyen connu mécanique et/ou chimique et/ou thermique et/ou photonique, etc.
- Sur au moins l'une des deux plaques de silicium 2, la zone utile Zu pour l'épitaxie 160 du film de nitrure de gallium 4 n'est couverte à ce stade que par le film d'oxyde silicium 6.
- On retire sélectivement 155 le film d'oxyde de silicium 6 à l'aplomb de ladite première surface 21 délimitée par le film de nitrure de silicium 3, ou du moins délimitée par ce qu'il en reste sur les bords des plaques ; ce retrait sélectif 155 comprend de préférence la gravure humide du film de silicium 6 à l'aplomb de ladite première surface 21, par exemple par une solution d'acide fluorhydrique.
- En particulier avant l'étape d'épitaxie 160, on peut avoir intérêt à procéder à un nettoyage de la ou des premières surfaces 21 de l'une ou des deux plaques de silicium 2, respectivement afin d'éliminer les particules présentes. Par exemple, on peut procéder à un nettoyage de type RCA (pour « Radio Corporation of America » selon la terminologie anglo-saxonne) limité à une étape SC-1 (pour « Standard Clean 1 » selon la terminologie anglo-saxonne comprenant une solution à base de NH₄OH-H₂O₂).
- L'au moins une des deux plaques de silicium 2 est alors prête pour le dépôt par épitaxie 160 dudit film de nitrure de gallium 4 au moins à l'aplomb de sa première surface 21.
- Pendant l'épitaxie 160, un film de nitrure de gallium 4 de bonne qualité est formé sur la première surface 21 de l'au moins une des deux plaques de silicium 2 ; en revanche, sur le chanfrein 20 de cette plaque, ce chanfrein 20 étant recouvert au moins en partie du film de nitrure de silicium 3 et du film d'oxyde de silicium 6, un film de nitrure de gallium 4 de mauvaise qualité est formé.
- Après épitaxie 160, ce qui reste du film de nitrure de silicium 3 (et la couche de GaN de mauvaise qualité) peut être retiré 161. Ce retrait 161 peut utiliser avec avantage la présence du film d'oxyde de silicium 6 sous-jacent comme déjà expliqué.
- Après le retrait 161 de ce qui reste du film de nitrure de silicium 3, on peut retirer 162, par exemple mécaniquement (par exemple par découpe ou par meulage), les bords de mauvaise qualité du film de nitrure de gallium 4, tout en gardant une taille maximale pour la zone utile Zu.
- En complément des techniques mécaniques permettant la rectification des bords du film de nitrure de gallium 4, on peut utiliser une attaque chimique pour retirer les contraintes et les dommages induits par ces techniques.

Quelques précisions sont données ci-dessous à titre exemplatif.

Les attaques chimiques du film d'oxyde de silicium 6 peuvent plus particulièrement être réalisées par une solution d'acide fluorhydrique à une concentration de 50% et/ou à chaud.

Le dépôt 140 du film de protection 3 peut être plus particulièrement réalisé par dépôt chimique en phase vapeur dans un four sous pression sous-atmosphérique à une température sensiblement égale à 750°C pour obtenir une épaisseur sensiblement égale à 50 nm pour ce film de protection 3.

La génération 125 de la couche additionnelle 6 peut être plus particulièrement réalisée dans un four sous pression atmosphérique à une température sensiblement égale à 950°C de vapeur d'eau pour obtenir une épaisseur sensiblement égale à 140 nm de la couche additionnelle 6.

Le dépôt de la couche de nucléation, au moins sur la première surface 21 d'une plaque 2, peut être réalisée par épitaxie en phase vapeur aux organométalliques à une température sensiblement comprise entre 1000 et 1200°C, de préférence comprise entre 1050 et 1100 °C.

Le dépôt par épitaxie 160 dudit film de nitrure de gallium 4 peut être plus particulièrement réalisé par épitaxie en phase vapeur aux organométalliques à une température sensiblement comprise entre 1000 et 1100°C, de préférence sensiblement égale à 1050°C, pour obtenir une épaisseur sensiblement égale à 3,5 µm dudit film de nitrure de gallium 4.

Quelques variantes des modes de réalisation décrits ci-dessus en références aux figures 1 et 2 sont décrites ci-dessous.

Selon un mode de réalisation différent des modes de réalisation illustrés sur les figures 1 et 2, le substrat de masquage 1 n'est pas une plaque de croissance 2. En particulier, le substrat peut être spécifique pour permettre un mode de séparation non dommageable pour la zone utile Zu de la plaque de croissance 2.

Le substrat de masquage 1 peut par exemple consister en une plaque au moins partiellement transparente pour permettre le décollement 150 de la plaque de croissance 2 depuis le substrat par application d'un rayonnement, de préférence laser, au moins sur une partie de ladite première surface 21 de la plaque de croissance 2 à travers le substrat 1.

La génération d'une couche additionnelle 6 telle que décrite ci-dessus n'est pas indispensable à la mise en oeuvre du procédé de l'invention; cependant, la couche additionnelle 6 fournit de nombreux avantages dont certains sont décrits ci-dessus et dont un autre avantage consiste à pouvoir envisager de graver localement dans le substrat de masquage 1 des vias 10, tels que représentés sur la figure 5, pour permettre l'amenée d'une solution d'attaque chimique sélective de la couche additionnelle 6 et permettre ainsi un décollement 150 chimique de la plaque de croissance 2 depuis le substrat 1.

Par ailleurs, comme illustré sur la figure 5, le substrat de masquage 1 peut être de dimensions supérieures aux dimensions de la plaque de croissance 2 de sorte que plusieurs plaques de croissance 2 peuvent être collées 130 sur le substrat 1.

Il est également envisagé que le substrat de masquage 1 puisse être réutilisable pour implémenter au moins une fois de plus le procédé de fabrication 100 en fournissant 110 à nouveau au moins une plaque de croissance 2.

Quel que soit le mode de réalisation considéré, chaque plaque de croissance 2 peut être couverte initialement au moins à l'aplomb de sa première surface 21 par une couche de nucléation, cette couche pouvant être déposée avant la couche additionnelle 6 ou pouvant servir elle-même de couche additionnelle 6. Cette couche de nucléation est mieux adaptée à la croissance cristalline de la couche épitaxiée 4 que la première surface 21 de la plaque de croissance 2.

Cette couche de nucléation permet de réduire les réactions chimiques entre le gallium et le silicium de la plaque de croissance 2, entrainant un phénomène destructif de creusement de cavités dans le silicium.

Ainsi, comme illustré sur la figure 3, le procédé de fabrication 100 peut comprendre, avant le collage 130 de la plaque de croissance 2 sur le substrat de masquage 1, et plus particulièrement avant la génération 125 de la couche additionnelle 6, une étape consistant à déposer 124 une couche de nucléation comprenant au moins un film de nitrure d'aluminium ou de nitrure d'aluminium-gallium ou encore de carbure de silicium (SiC). Dans ce cas, la génération 125 de la couche additionnelle 6 peut être réalisée par dépôt (plutôt que par oxydation en surface de la plaque 2) de sorte que la couche de nucléation puisse être protégée par ladite couche additionnelle 6 notamment lors du collage 130 et jusqu'au décollement 150. Le dépôt 124 de ladite couche de nucléation peut être réalisée par LPCVD ou par épitaxie en phase vapeur aux organométalliques à une température sensiblement comprise entre 1000 et 1200°C, de préférence comprise entre 1050 et 1100°C.

Comme vu précédemment, un des avantages majeurs du procédé de fabrication 100 selon l'invention est que le film de protection 3 est auto-aligné sur le chanfrein 20 et que la première surface 21 de la plaque de croissance 2 correspond avantageusement à la zone utile Zu à l'épitaxie 160, cette zone se trouvant ainsi avantageusement maximisée. La première surface étant automatiquement délimitée par le chanfrein 20 de la plaque de croissance 2, la zone d'exclusion Ze s'étend sur le chanfrein potentiellement depuis la première surface 21 de la plaque de croissance 2 et se trouve minimisée corrélativement à la maximisation de la zone utile Zu. Il est encore possible que la dimension du chanfrein 20 de la plaque de croissance 2 puisse être adaptée pour minimiser la zone d'exclusion et corrélativement maximiser encore davantage la zone utile Zu.

En ce qui concerne le dépôt 140 dudit au moins un film de protection 3, plusieurs techniques de dépôts peuvent être envisagés en fonction de la nature du ou des films de protection 3 ; on peut citer les dépôts en phase vapeur dans un four sous pression sous-atmosphérique ou LPCVD, en phase vapeur assisté par plasma PECVD (pour « Plasma-Enhanced Chemical Vapor Déposition » selon la terminologie anglo-saxonne), physique en phase vapeur ou PVD (pour « Physical Vapor Déposition » selon la terminologie anglo-saxonne), etc.

Le film de nitrure de silicium peut être remplacé par un autre film de protection 3, par exemple en oxyde de silicium. Ce film de protection doit être capable de supporter les traitements thermiques ultérieurs (et notamment la température d'épitaxie).

En présence d'une couche additionnelle 6 sous-jacente, de nombreux matériaux peuvent être utilisés pour réaliser le film de protection 3 (et notamment AIN par exemple) en prévoyant des ouvertures pour accéder à la couche additionnelle 6. Ils seront éliminés, de même que la couche qui aura pu croitre dessus au moment de l'épitaxie par lift off à l'aide de la couche additionnelle 6.

Il est possible également que le film de protection 3 et la couche additionnelle 6 soient réalisée dans le même matériau (par exemple en oxyde de silicium). Dans ce cas, plutôt que la sélectivité de gravure entre le film de protection 3 et la couche additionnelle 6, on utilisera la différence d'épaisseur au niveau de la zone utile et de la zone complémentaire pour ajuster le temps de gravure et conserver du matériau au niveau de la zone complémentaire uniquement tout en mettant à nu la plaque de croissance 2 (ou l'éventuelle couche de nucléation) au niveau de la zone utile.

Les procédés de collage 130 direct incluent les diverses variantes de préparation de surface, de nettoyage, d'atmosphères de collage, de contact des plaques, des traitements thermiques pré-collages, etc. Le contact des plaques peut être réalisé manuellement ou automatiquement. Les plaques de croissance 2 peuvent être alignées avant collage de façon à minimiser la zone d'exclusion Ze et maximiser la zone utile Zu ; cet alignement peut être réalisé mécaniquement ou par le biais de marques d'alignement.

Le décollement 150 des plaques de croissance 2 peut se faire, outre par attaque chimique, par un effort mécanique, par exemple par insertion d'un coin, appliqué localement ou sur le pourtour des surfaces collées entre elles, et/ou dans une atmosphère qui favorise ou non le décollement 150.

Les retraits sont réalisés par voie mécanique et/ou chimique, en procédé sec, gazeux ou liquide, parmi lesquels on peut citer le meulage (ou « grinding » selon la terminologie anglo-saxonne), le polissage à sec (ou « dry polishing » selon la terminologie anglo-saxonne), la CMP, les attaques en solutions liquides chimiques, les gravures chimiques par atmosphères spécifiques, les gravures par plasma ou par faisceau d'ions, etc.

Le retrait 154, 156 dudit au moins un film de protection 3, et éventuellement de ladite couche additionnelle 6, en face arrière 26 de la plaque de croissance 2 peut être fait avant ou après décollement 150 des plaques. En particulier, le retrait 154, 156 peut être difficile par une CMP (ou autre technique) sur une structure de deux plaques collées (puisque l'épaisseur de la structure collée est le total de celle des deux plaques). Alors pour ce retrait 154, 156, il peut être préférable de décoller les plaques 2, puis de faire le retrait 154, 156 (par CMP ou autre technique) sur chacune des plaques 2 séparément.

L'invention n'est pas limitée aux modes de réalisation décrits ci-dessus et s'étend à tous les modes de réalisation couverts par les revendications.

## Revendications

1. Procédé de fabrication (100) d'une couche épitaxiée (4) sur au moins une plaque de croissance (2) comprenant les étapes suivantes:
- fournir (110) un substrat de masquage (1),
- fournir (120) au moins une plaque de croissance (2) comprenant un chanfrein (20),
- coller (130) ladite au moins une plaque de croissance (2) sur le substrat de masquage (1), de sorte que le substrat de masquage (1) masque une première surface (21) et expose une deuxième surface (22) de ladite au moins une plaque (2), ladite deuxième surface (22) comprenant le chanfrein (20) et ladite première surface (21) étant au moins en partie délimitée par le chanfrein (20),
- après l'étape de collage (130), déposer (140) au moins un film de protection (3) au moins sur une partie du chanfrein (20) de ladite au moins une plaque de croissance (2),
- décoller (150) ladite au moins une plaque de croissance (2) depuis le substrat de masquage (1), et
- après l'étape de décollement (150), déposer (160) au moins une couche épitaxiée (4) à partir de ladite première surface (21) de ladite au moins une plaque de croissance (2).

2. Procédé selon la revendication précédente, dans lequel le substrat de masquage (1) est de dimensions supérieures aux dimensions de ladite au moins une plaque de croissance (2) de sorte que plusieurs plaques de croissance (2) peuvent être collées (130) sur le substrat (1), et dans lequel le substrat de masquage (1) est de préférence réutilisable pour effectuer successivement plusieurs séquences d'étapes avec des plaques de croissance (2) différentes, chaque séquence comprenant au moins ledit collage (130) et ledit décollement (150).

3. Procédé selon l'une quelconque des revendications précédentes, dans lequel le substrat (1) est transparent pour permettre le décollement (150) par application d'un rayonnement, de préférence laser, au moins sur une partie de ladite première surface (21) à travers le substrat de masquage (1).

4. Procédé selon la revendication 1, dans lequel, ledit substrat de masquage (1) est une plaque de croissance (2) comprenant un chanfrein (20), le procédé comprend les étapes consistant à :
- fournir (110, 120) deux plaques de croissance (2) comprenant chacune un chanfrein (20),
- coller (130) les deux plaques de croissance (2) l'une sur l'autre, de sorte que chaque plaque de croissance (2) masque une première surface (21) et expose une deuxième surface (22) de l'autre des deux plaques de croissance (2), la deuxième surface (22) de chaque plaque de croissance (2) comprenant le chanfrein (20) de cette plaque de croissance (2) et la première surface (21) de chaque plaque de croissance (2) étant au moins en partie délimitée par le chanfrein (20) de cette plaque (2),
- déposer (140) ledit au moins un film de protection (3) au moins sur une partie du chanfrein (20) d'au moins une des deux plaques de croissance (2),
- décoller (150) lesdites deux plaques de croissance (2) entre elles, et
- déposer par épitaxie (160) au moins une couche épitaxiée (4) à partir de la première surface (21) d'au moins une des deux plaques de croissance (2).

5. Procédé selon l'une quelconque des revendications précédentes, dans lequel le collage (130) est réalisé de sorte que ladite première surface (21) soit maximale.

6. Procédé selon l'une quelconque des revendications précédentes, dans lequel le collage (130) est réalisé par collage direct.

7. Procédé selon l'une quelconque des revendications précédentes, dans lequel ledit au moins un film de protection (3) comprend au moins un film de nitrure, de préférence un film de nitrure de silicium, ou un film d'oxyde, de préférence un film d'oxyde de silicium.

8. Procédé selon l'une quelconque des revendications précédentes, comprenant l'étape suivante, avant le collage (130) de ladite au moins une plaque de croissance (2) sur le substrat de masquage (1) : déposer (124) au moins une couche de nucléation comprenant un film d'un nitrure choisi parmi le nitrure d'aluminium (AIN), le nitrure d'indium (InN), le nitrure d'aluminium-gallium (AIGaN), le nitrure d'indium-gallium (InGaN) au moins sur la première surface (21) de ladite au moins une plaque de croissance (2).

9. Procédé selon l'une quelconque des revendications 1 à 7 comprenant :
- avant l'étape de collage (130), générer (125) une couche additionnelle (6) au moins à l'aplomb de la première surface (21) de ladite au moins une plaque de croissance (2), la génération (125) de la couche additionnelle (6) comprenant de préférence l'un parmi une oxydation en surface de ladite au moins une plaque de croissance (2) et un dépôt de la couche additionnelle (6), et
- après le décollement (150) de ladite au moins une plaque de croissance (2) depuis le substrat de masquage (1) et avant l'étape de dépôt (160) de ladite couche épitaxiée (4), retirer (155) la couche additionnelle (6) à l'aplomb de ladite première surface (21) de préférence par sa gravure humide sélectivement au film de protection (3), par exemple par une solution d'acide fluorhydrique.

10. Procédé selon la revendication précédente, comprenant l'étape suivante, avant la génération (125) de la couche additionnelle (6) : déposer (124) au moins une couche de nucléation comprenant un film d'un nitrure choisi parmi le nitrure d'aluminium (AIN), le nitrure d'aluminium-gallium (AIGaN) et le carbure de silicium (SiC), au moins sur la première surface (21) de ladite au moins une plaque de croissance (2).

11. Procédé selon l'une quelconque des deux revendications précédentes, comprenant l'étape suivante, après le collage (130) de ladite au moins une plaque de croissance (2) sur le substrat de masquage (1) et avant le dépôt (140) dudit au moins un film de protection (3): retirer (135) la couche additionnelle (6) à l'aplomb de ladite deuxième surface (22).

12. Procédé selon l'une quelconque des trois revendications précédentes, dans lequel ledit substrat de masquage (1) comprend des vias (10) pour permettre l'amenée jusqu'à la couche additionnelle (6) située à l'aplomb de la première surface (21) d'une solution d'attaque chimique de la couche additionnelle (6).

13. Procédé selon l'une quelconque des revendications précédentes dans lequel, l'étape de dépôt (140) d'au moins un film de protection (3) comprenant le dépôt dudit au moins un film de protection (3) sur une face arrière (26) de la plaque de croissance (2) opposée à une face avant (25) comprenant ladite première surface (21), le procédé comprend l'étape suivante, après le décollement (150) de ladite au moins une plaque de croissance (2) depuis le substrat de masquage (1) et avant l'étape de dépôt par épitaxie (160) de la couche épitaxiée (4) : retirer (154, 156), depuis ladite face arrière (26), au moins ledit au moins un film de protection (3) jusqu'à exposer une troisième surface (23) de ladite au moins une plaque de croissance (2) opposée à ladite première surface (21), ce retrait (154, 156) comprenant de préférence le retrait mécanique par meulage d'au moins ledit au moins un film de protection (3) au moins à l'aplomb de ladite troisième surface (23).

14. Procédé selon l'une quelconque des revendications précédentes, comprenant en outre l'étape suivante, après l'étape de dépôt (160) de la couche épitaxiée (4) : retirer (161) au moins ce qui reste dudit au moins un film de protection (3) jusqu'à exposer toute la surface de ladite au moins une plaque de croissance (2) non recouverte par ladite couche épitaxiée (4).

15. Procédé selon la revendication 9 prise dans sa combinaison avec la revendication précédente, dans lequel le retrait (161) de ce qui reste dudit au moins un film de protection (3) comprend la gravure par une solution d'attaque chimique, par exemple une solution d'acide fluorhydrique, de ce qui reste de la couche additionnelle (6), ce retrait (161) étant de préférence précédé d'au moins une ouverture dudit au moins film de protection (3) pour permettre l'amenée de ladite solution d'attaque chimique.

16. Procédé selon l'une quelconque des deux revendications précédentes, dans lequel la couche épitaxiée (4) recouvrant par ses bords en partie ledit au moins un film de protection (3) recouvrant lui-même le chanfrein (20), le procédé comprend, après le retrait (161) de ce qui reste dudit au moins un film de protection (3) : retirer (162) les bords de la couche épitaxiée (4), par exemple par meulage suivi de préférence par une gravure humide.

## Patentansprüche

1. Verfahren zur Herstellung (100) einer epitaktischen Schicht (4) auf mindestens einer Wachstumsplatte (2), das die folgenden Schritte umfasst:
- Bereitstellen (110) eines Maskensubstrats (1),
- Bereitstellen (120) von mindestens einer Wachstumsplatte (2), die eine Fase (20) umfasst,
- Kleben (130) der mindestens einen Wachstumsplatte (2) auf das Maskensubstrat (1), sodass das Maskensubstrat (1) eine erste Fläche (21) der mindestens einen Platte (2) maskiert und eine zweite Fläche (22) derselben freilegt, wobei die zweite Fläche (22) die Fase (20) umfasst und wobei die erste Fläche (21) mindestens zum Teil von der Fase (20) begrenzt wird,
- nach dem Schritt des Klebens (130), Abscheiden (140) von mindestens einem Schutzfilm (3) auf mindestens einem Teil der Fase (20) der mindestens einen Wachstumsplatte (2),
- Ablösen (150) der mindestens einen Wachstumsplatte (2) vom Maskensubstrat (1), und
- nach dem Schritt des Ablösens (150), Abscheiden (160) von mindestens einer epitaktischen Schicht (4) ausgehend von der ersten Fläche (21) der mindestens einen Wachstumsplatte (2).

2. Verfahren nach dem vorstehenden Anspruch, wobei das Maskensubstrat (1) größere Abmessungen aufweist als die Abmessungen der mindestens einen Wachstumsplatte (2), sodass mehrere Wachstumsplatten (2) auf das Substrat (1) geklebt (130) werden können, und wobei das Maskensubstrat (1) vorzugsweise wiederverwendet werden kann, um nacheinander mehrere Schrittfolgen mit unterschiedlichen Wachstumsplatten (2) vorzunehmen, wobei jede Folge mindestens das Kleben (130) und das Ablösen (150) umfasst.

3. Verfahren nach einem der vorstehenden Ansprüche, wobei das Substrat (1) transparent ist, um das Ablösen (150) durch Anwenden einer Strahlung, vorzugsweise Laser, auf mindestens einen Teil der ersten Fläche (21) durch das Maskensubstrat (1) hindurch zu ermöglichen.

4. Verfahren nach Anspruch 1, wobei es sich bei dem Maskensubstrat (1) um eine Wachstumsplatte (2) handelt, die eine Fase (20) umfasst, wobei das Verfahren die Schritte umfasst, die darin bestehen:
- zwei Wachstumsplatten (2) bereitzustellen (110, 120), die je eine Fase (20) umfassen,
- die zwei Wachstumsplatten (2) aufeinander zu kleben (130), sodass jede Wachstumsplatte (2) eine erste Fläche (21) der anderen der zwei Wachstumsplatten (2) maskiert und eine zweite Fläche (22) derselben freilegt, wobei die zweite Fläche (22) jeder Wachstumsplatte (2) die Fase (20) dieser Wachstumsplatte (2) umfasst und die erste Fläche (21) jeder Wachstumsplatte (2) mindestens zum Teil von der Fase (20) dieser Platte (2) begrenzt wird,
- den mindestens einen Schutzfilm (3) auf mindestens einem Teil der Fase (20) mindestens einer der zwei Wachstumsplatten (2) abzuscheiden (140),
- die zwei Wachstumsplatten (2) voneinander abzulösen (150), und
- mindestens eine epitaktische Schicht (4) ausgehend von der ersten Fläche (21) mindestens einer der zwei Wachstumsplatten (2) mittels Epitaxie abzuscheiden (160).

5. Verfahren nach einem der vorstehenden Ansprüche, wobei das Kleben (130) so ausgeführt wird, dass die erste Fläche (21) maximal ist.

6. Verfahren nach einem der vorstehenden Ansprüche, wobei das Kleben (130) durch direktes Kleben ausgeführt wird.

7. Verfahren nach einem der vorstehenden Ansprüche, wobei der mindestens eine Schutzfilm (3) mindestens einen Nitridfilm, vorzugsweise einen Siliciumnitridfilm, oder einen Oxidfilm, vorzugsweise einen Siliciumoxidfilm, umfasst.

8. Verfahren nach einem der vorstehenden Ansprüche, das vor dem Kleben (130) der mindestens einen Wachstumsplatte (2) auf das Maskensubstrat (1) den folgenden Schritt umfasst: Abscheiden (124) von mindestens einer Keimbildungsschicht, die einen Film aus einem Nitrid, ausgewählt aus Aluminiumnitrid (AIN), Indiumnitrid (InN), Aluminium-Gallium-Nitrid (AIGaN), Indium-Gallium-Nitrid (InGaN) umfasst, auf mindestens der ersten Fläche (21) der mindestens einen Wachstumsplatte (2).

9. Verfahren nach einem der Ansprüche 1 bis 7, umfassend:
- vor dem Schritt des Klebens (130), Erzeugen (125) einer zusätzlichen Schicht (6) mindestens lotrecht zur ersten Fläche (21) der mindestens einen Wachstumsplatte (2), wobei das Erzeugen (125) der zusätzlichen Schicht (6) vorzugsweise eines aus einer Oberflächenoxidation der mindestens einen Wachstumsplatte (2) und einem Abscheiden der zusätzlichen Schicht (6) umfasst, und
- nach dem Ablösen (150) der mindestens einen Wachstumsplatte (2) vom Maskensubstrat (1) und vor dem Schritt des Abscheidens (160) der epitaktischen Schicht (4), Entfernen (155) der zusätzlichen Schicht (6) lotrecht zur ersten Fläche (21) vorzugsweise durch deren in Bezug auf den Schutzfilm (3) selektives Nassätzen, zum Beispiel mittels einer Fluorwasserstoffsäurelösung.

10. Verfahren nach dem vorstehenden Anspruch, das vor dem Erzeugen (125) der zusätzlichen Schicht (6) den folgenden Schritt umfasst: Abscheiden (124) von mindestens einer Keimbildungsschicht, die einen Film aus einem Nitrid, ausgewählt aus Aluminiumnitrid (AIN), Aluminium-Gallium-Nitrid (AIGaN) und Siliciumcarbid (SiC) umfasst, auf mindestens der ersten Fläche (21) der mindestens einen Wachstumsplatte (2).

11. Verfahren nach einem der zwei vorstehenden Ansprüche, das nach dem Kleben (130) der mindestens einen Wachstumsplatte (2) auf das Maskensubstrat (1) und vor dem Abscheiden (140) des mindestens einen Schutzfilms (3) den folgenden Schritt umfasst: Entfernen (135) der zusätzlichen Schicht (6) lotrecht zur zweiten Fläche (22).

12. Verfahren nach einem der drei vorstehenden Ansprüche, wobei das Maskensubstrat (1) Durchkontaktierungen (10) umfasst, um das Zuführen einer Lösung zum chemischen Angreifen der zusätzlichen Schicht (6) bis zu der lotrecht zur ersten Fläche (21) liegenden zusätzlichen Schicht (6) zu ermöglichen.

13. Verfahren nach einem der vorstehenden Ansprüche, wobei, wenn der Schritt des Abscheidens (140) von mindestens einem Schutzfilm (3) das Abscheiden des mindestens einen Schutzfilms (3) auf einer Rückseite (26) der Wachstumsplatte (2) umfasst, die einer die erste Fläche (21) umfassenden Vorderseite (25) gegenüberliegt, das Verfahren nach dem Ablösen (150) der mindestens einen Wachstumsplatte (2) vom Maskensubstrat (1) und vor dem Schritt des Abscheidens (160) der epitaktischen Schicht (4) mittels Epitaxie den folgenden Schritt umfasst: Entfernen (154, 156) mindestens des mindestens einen Schutzfilms (3) von der Rückseite (26), bis eine dritte Fläche (23) der mindestens einen Wachstumsplatte (2), die der ersten Fläche (21) gegenüberliegt, freigelegt ist, wobei dieses Entfernen (154, 156) vorzugsweise das mechanische Entfernen mittels Schleifen mindestens des mindestens einen Schutzfilms (3) mindestens lotrecht zur dritten Fläche (23) umfasst.

14. Verfahren nach einem der vorstehenden Ansprüche, das nach dem Schritt des Abscheidens (160) der epitaktischen Schicht (4) weiter den folgenden Schritt umfasst: Entfernen (161) mindestens dessen, was von dem mindestens einen Schutzfilm (3) verbleibt, bis die gesamte Fläche der mindestens einen Wachstumsplatte (2), die nicht von der epitaktischen Schicht (4) bedeckt ist, freigelegt ist.

15. Verfahren nach Anspruch 9 in Kombination mit dem vorstehenden Anspruch, wobei das Entfernen (161) dessen, was von dem mindestens einen Schutzfilm (3) verbleibt, das Ätzen mittels einer chemischen Angriffslösung, zum Beispiel einer Fluorwasserstoffsäurelösung, dessen, was von der zusätzlichen Schicht (6) verbleibt, umfasst, wobei diesem Entfernen (161) vorzugsweise mindestens ein Öffnen des mindestens einen Schutzfilms (3) vorangeht, um das Zuführen der chemischen Angriffslösung zu ermöglichen.

16. Verfahren nach einem der zwei vorstehenden Ansprüche, wobei, wenn die epitaktische Schicht (4) mittels ihrer Ränder zum Teil den mindestens einen Schutzfilm (3) bedeckt, der seinerseits die Fase (20) bedeckt, das Verfahren nach dem Entfernen (161) dessen, was von dem mindestens einen Schutzfilm (3) verbleibt, umfasst: Entfernen (162) der Ränder der epitaktischen Schicht (4), zum Beispiel mittels Schleifen, vorzugsweise gefolgt von einem Nassätzen.

## Claims

1. Method for producing (100) a epitaxially grown layer (4) on at least one growth plate (2) comprising the following steps:
- providing (110) a masking substrate (1),
- providing (120) at least one growth plate (2) comprising a chamfer (20),
- bonding (130) said at least one growth plate (2) on the masking substrate (1), such that the masking substrate (1) masks a first surface (21) and exposes a second surface (22) of said at least one plate (2), said second surface (22) comprising the chamfer (20) and said first surface (21) being at least partially delimited by the chamfer (20),
- after the bonding step (130), depositing (140) at least one protective film (3) at least on one portion of the chamfer (20) of said at least one growth plate (2),
- debonding (150) said at least one growth plate (2) from the masking substrate (1), and
- after the debonding step (150), depositing (160) at least one epitaxially grown layer (4) from said first surface (21) of said at least one growth plate (2).

2. Method according to the preceding claim, wherein the masking substrate (1) is of dimensions greater than the dimensions of said at least one growth plate (2) such that several growth plates (2) can be bonded (130) on the substrate (1), and wherein the masking substrate (1) is preferably reusable to successively carry out several sequences of steps with different growth plates (2), each sequence comprising at least said bonding (130) and said debonding (150).

3. Method according to any one of the preceding claims, wherein the substrate (1) is transparent to make it possible for the debonding (150) by application of a radiation, preferably laser, at least on one portion of said first surface (21) through the masking substrate (1).

4. Method according to claim 1, wherein said masking substrate (1) is a growth plate (2) comprising a chamfer (20), the method comprises steps consisting of:
- providing (110, 120) two growth plates (2) each comprising a chamfer (20),
- bonding (130) the two growth plates (2) on one another, such that each growth plate (2) masks a first surface (21) and exposes a second surface (22) of the other of the two growth plates (2), the second surface (22) of each growth plate (2) comprising the chamfer (20) of this growth plate (2) and the first surface (21) of each growth plate (2) being at least partially delimited by the chamfer (20) of each plate (2),
- depositing (140) said at least one protective film (3) at least on one portion of the chamfer (20) of at least one of the two growth plates (2),
- debonding (150) said two growth plates (2) from one another, and
- depositing by epitaxy (160) at least one epitaxially grown layer (4) from the first surface (21) of at least one of the two growth plates (2).

5. Method according to any one of the preceding claims, wherein the bonding (130) is carried out such that said first surface (21) is maximal.

6. Method according to any one of the preceding claims, wherein the bonding (130) is carried out by direct bonding.

7. Method according to any one of the preceding claims, wherein said at least one protective film (3) comprises at least one nitride film, preferably a silicon nitride film, or an oxide film, preferably a silicon oxide film.

8. Method according to any one of the preceding claims, comprising the following step, before the bonding (130) of said at least one growth plate (2) on the masking substrate (1): depositing (124) at least one nucleation layer comprising a film of a nitride selected from among aluminium nitride (AIN), indium nitride (InN), aluminium-gallium nitride (AIGaN), indium-gallium nitride (InGaN) at least one the first surface (21) of said at least one growth plate (2).

9. Method according to any one of claims 1 to 7 comprising:
- before the bonding step (130), generating (125) an additional layer (6) at least just under the first surface (21) of said at least one growth plate (2), the generation (125) of the additional layer (6) preferably comprising one from among an oxidation on the surface of said at least one growth plate (2) and a deposition of the additional layer (6), and
- after the debonding (150) of said at least one growth plate (2) from the masking substrate (1) and before the step of depositing (160) said epitaxially grown layer (4), removing (155) the additional layer (6) just under said first surface (21), preferably by the wet etching thereof selectively on the protective film (3), for example by a hydrofluoric acid solution.

10. Method according to the preceding claim, comprising the following step, before the generation (125) of the additional layer (6): depositing (124) at least one nucleation layer comprising a film of a nitride selected from among aluminium nitride (AIN), aluminium-gallium nitride (AIGaN) and silicon carbide (SiC), at least on the first surface (21) of said at least one growth plate (2).

11. Method according to any one of the two preceding claims, comprising the following step, after the bonding (130) of said at least one growth plate (2) on the masking substrate (1) and before the deposition (140) of said at least one protective film (3): removing (135) the additional layer (6) just under said second surface (22).

12. Method according to any one of the three preceding claims, wherein said masking substrate (1) comprises vias (10) to make it possible for the supply to the additional layer (6) located just under the first surface (21) of a solution to etch the additional layer (6).

13. Method according to any one of the preceding claims, wherein the step of depositing (140) at least one protective film (3) comprising the deposition of said at least one protective film (3) on a rear face (26) of the growth plate (2) opposite a front face (25) comprising said first surface (21), the method comprises the following step, after the debonding (150) of said at least one growth plate (2) from the masking substrate (1) and before the step of depositing by epitaxy (160) of the epitaxially grown layer (4): removing (154, 156) from said rear face (26), at least said at least one protective film (3) until exposing a third surface (23) of said at least one growth plate (2) opposite said first surface (21), this removal (154, 156) preferably comprising the mechanical removal by grinding at least said at least one protective film (3) at least just under said third surface (23).

14. Method according to any one of the preceding claims, further comprising the following step, after the step of depositing (160) the epitaxially grown layer (4): removing (161) at least what remains of said at least one protective film (3) until exposing the whole surface of said at least one growth plate (2) not covered by said epitaxially grown layer (4).

15. Method according to claim 9, taken in the combination thereof with the preceding claim, wherein the removal (161) of what remains of said at least one protective film (3) comprises the etching by an etching solution, for example a hydrofluoric acid solution, of what remains of the additional layer (6), this removal (161) preferably being preceded by at least one opening of said at least one protective film (3) to make it possible for the supply of said etching solution.

16. Method according to any one of the two preceding claims, wherein the epitaxially grown layer (4) partially covering by the edges thereof said at least one protective film (3) itself covering the chamfer (20), the method comprises, after the removal (161) of what remains of said at least one protective film (3): removing (162) the edges of the epitaxially grown layer (4), for example by grinding followed preferably by a wet etching.
